# EUROPÄISCHE PATENTSCHRIFT

(11) **EP 3 576 898 B1**
(45) Veröffentlichungstag und Bekanntmachung des Hinweises auf die Patenterteilung: **29.12.2021**
(21) Anmeldenummer: 18702632.3
(22) Anmeldetag: 22.01.2018
(51) Int. Cl.: B23K 1/00, B23K 1/005, B23K 1/20, H05K 3/34, B23K 101/42

(54) **VERFAHREN ZUM FÜGEN VON BAUTEILEN AUF EINE TRÄGERSTRUKTUR UNTER EINSATZ VON ELEKTROMAGNETISCHER STRAHLUNG**
METHOD FOR JOINING COMPONENTS ON A SUPPORT STRUCTURE USING ELECTROMAGNETIC RADIATION
PROCÉDÉ PERMETTANT D'ASSEMBLER DES COMPOSANTS SUR UNE STRUCTURE DE SUPPORT AU MOYEN D'UN RAYONNEMENT ÉLECTROMAGNÉTIQUE

(30) Priorität: 02.02.2017 DE 102017201679
(43) Veröffentlichungstag der Anmeldung: 11.12.2019
(73) Patentinhaber: Fraunhofer-Gesellschaft zur Förderung der angewandten Forschung e.V., 80686 München (DE)
(72) Erfinder: LÖHRING, Jens, 6291 LA Vaals (NL); HOFFMANN, Hans-Dieter, 52152 Simmerath (DE); TRAUB, Martin, 52146 Würselen (DE); WINZEN, Matthias, 52072 Aachen (DE); BRANDENBURG, Wolfgang, 52072 Aachen (DE); FAIDEL, Heinrich, 52146 Würselen (DE); JANSSEN, Michael, 52074 Aachen (DE); PLUM, Heinz-Dieter, 52074 Aachen (DE)
(74) Vertreter: Gagel, Roland
(86) Internationale Anmeldenummer: PCT/EP2018/051450
(87) Internationale Veröffentlichungsnummer: WO 2018/141568

(56) Entgegenhaltungen:
- CA-A1- 2 960 042
- GB-A- 2 244 374
- JP-A- S6 431 126
- JP-A- H05 109 824
- JP-A- H10 190 209
- JP-A- H10 214 859
- US-B1- 6 380 513
- JIN S: "Rare-earth-enabled universal solders for microelectromechanical systems and optical packaging", JOURNAL OF ELECTRONIC MATERI, WARRENDALE, PA, US, Bd. 32, Nr. 12, 1. Dezember 2003 (2003-12-01), Seiten 1366-1370, XP009091451, ISSN: 0361-5235, DOI: 10.1007/S11664-003-0102-6

## Beschreibung

### Technisches Anwendungsgebiet

Die vorliegende Erfindung betrifft ein Verfahren zum Fügen von optischen Bauteilen, auf eine Trägerstruktur unter Einsatz von elektromagnetischer Strahlung, wobei die Bauteile und/oder die Trägerstruktur als zu fügende Komponenten wenigstens teilweise durchlässig für die elektromagnetische Strahlung sind. Ein derartiges Verfahren lässt sich in vielen technischen Bereichen einsetzen, in denen mikrooptische Komponenten oder andere Bauteile mit hoher Genauigkeit mit einer Trägerstruktur verbunden werden müssen. Beispiele sind hybride Mikrosysteme, mikrooptische Systeme, Laserstrahlquellen oder Baugruppen mit optischen Komponenten.

### Stand der Technik

Aus der WO 2004/050287 A1 ist ein Verfahren zur Lötbefestigung miniaturisierter Bauteile auf einer Grundplatte bekannt, bei dem Laserstrahlung durch die Unterseite einer mindestens teilweise für die Laserstrahlung transparenten Grundplatte auf ein Lötmaterial gerichtet wird, um dieses aufzuschmelzen. Die Grundplatte weist auf der Oberseite im Bereich des Befestigungsabschnitts eine Metallschicht auf, durch die eine ausreichende Benetzung durch das Lot sichergestellt werden soll.

Die DE 10240355 A1 beschreibt ein Verfahren zum stoffschlüssigen Verbinden von zwei Körpern durch eine flussmittelfreie Lötverbindung, wobei auf komplementären Oberflächenbereichen der Körper jeweils ein Dünnschichtsystem aufgebracht wird, das mindestens aus einer aus Titan bestehenden Haftschicht, einer aus Platin bestehenden Barriereschicht und einer Lotschicht aus einer Gold-/Zinn-Legierung gebildet ist.

Das wesentliche Merkmal dieser bekannten Verfahren ist die Verwendung von metallischen Beschichtungen auf den zu verbindenden Oberflächenbereichen, um dadurch eine Benetzungsfähigkeit mit flussmittelfreien Loten herzustellen. Vor allem beim Fügen von optischen Komponenten dürfen keine flussmittelhaltigen Lote verwendet werden, da die entsprechenden organischen Lotzusätze zu einer Kontamination und damit zu einer Schädigung von optischen Bauteilen führen können.

Die US 2004/0245228 A1 beschreibt ein Verfahren zur Verbindung von optischen und mikroelektronischen Bauteilen mit Hilfe laserunterstützter Lötprozesse, bei dem ebenfalls ein flussmittelfreies Lot eingesetzt wird. Die Oxidation des Lotes wird dabei durch Evakuierung oder den Einsatz eines geeigneten Schutzgases verhindert, um dadurch eine ausreichende Benetzung der Oberflächen mit dem Lot zu erreichen. Praktische Erfahrungen zeigen jedoch, dass trotz dieser Maßnahme insbesondere auf Gläsern keine zufriedenstellende Benetzung erreicht werden kann, wenn die Oberflächen nicht mit geeigneten Beschichtungen versehen werden.

Aus S. Jin, "Rare-Earth-Enabled Universal Solders for Microelectromechanical Systems and Optical Packaging", Journal of Electronic Materials, Vol. 32, No. 12, 2003, Seiten 1366 bis 1370 sind flussmittelfreie Lotmaterialien bekannt, bei denen eine Kodotierung mit seltenen Erden für eine Benetzungsfähigkeit auch auf Gläsern sorgt. Die in dieser Druckschrift eingesetzten Löttechniken basieren jedoch nicht auf dem Einsatz elektromagnetischer Strahlung.

Die US 6 380 513 B (Basis für die Erfindung) offenbart ein Verfahren zum Fügen von optischen Bauteilen, auf eine Trägerstruktur (1) unter Einsatz von elektromagnetischer Strahlung, wobei die Bauteile (2) und/oder die Trägerstruktur (1) als zu fügende Komponenten wenigstens teilweise durchlässig für die elektromagnetische Strahlung (4) sind.

Die bisher zur Verbindung mikrooptischer Komponenten mit Trägerstrukturen eingesetzten Löttechniken unter Einsatz elektromagnetischer Strahlung erfordern zur Herstellung einer zuverlässigen Lotverbindung das Aufbringen einer Beschichtung auf die zu verbindenden Oberflächenbereiche, durch die eine ausreichende Benetzungsfähigkeit für das Lot hergestellt wird. Die hierfür erforderlichen Beschichtungsvorgänge können jedoch vor allem bei optischen Komponenten eine Kontamination der optischen Funktionsflächen hervorrufen, die durch geeignete Maßnahmen vermieden werden muss. Dies erhöht jedoch die Kosten für den Fügeprozess.

Weiterhin erfordert eine derartige Beschichtung vor allem bei stark unterschiedlichen Wärmeleitfähigkeiten der zu verbindenden Komponenten, kleine und präzise einstellbare Leistungen der elektromagnetischen Strahlung, um die Löttemperatur an der Beschichtungsfläche zu erzielen. Sobald eine stoffschlüssige Verbindung mit dem Lot erreicht ist, müssen die Prozessparameter aufgrund der dann stattfindenden hohen Wärmeleitung in die Trägerstruktur stark angepasst werden. Dieser Prozessübergang hängt von den Materialeigenschaften wie Wärmekapazität, Wärmeleitung sowie Geometrie der zu fügenden Komponenten ab, so dass der Lötprozess jeweils präzise an die jeweilige Konstellation angepasst werden muss.

Die Aufgabe der vorliegenden Erfindung besteht darin, ein Verfahren zum Fügen von optischen Bauteilen auf eine Trägerstruktur unter Einsatz elektromagnetischer Strahlung anzugeben, das sich einfacher durchführen lässt und insbesondere eine flussmittelfreie Lötverbindung mikrooptischer Bauteile mit einer Trägerstruktur ermöglicht.

### Darstellung der Erfindung

Die Aufgabe wird mit dem Verfahren gemäß Patentanspruch 1 gelöst. Vorteilhafte Ausgestaltungen des Verfahrens sind Gegenstand der abhängigen Patentansprüche oder lassen sich der nachfolgenden Beschreibung sowie den Ausführungsbeispielen entnehmen.

Bei dem vorgeschlagenen Verfahren zum Fügen von optischen Bauteilen, auf eine Trägerstruktur sind die Bauteile und/oder die Trägerstruktur als zu fügende Komponenten wenigstens teilweise für die zur Herstellung einer Lötverbindung eingesetzte elektromagnetische Strahlung, insbesondere optische Strahlung, durchlässig. Bei dem Verfahren wird auf wenigstens einen von jeweils zwei zum Fügen zu verbindenden Oberflächenbereichen der Bauteile und der Trägerstruktur oder zwischen jeweils zwei zu verbindende Oberflächenbereiche der Bauteile und der Trägerstruktur ein Lot aufgebracht oder eingebracht. Die zu verbindenden Oberflächenbereiche werden anschließend durch Aufschmelzen des Lotes mit Hilfe der elektromagnetischen Strahlung, vorzugsweise von Laserstrahlung, und anschließende Abkühlung stoffschlüssig miteinander verbunden. Das Verfahren zeichnet sich dadurch aus, dass als Lot ein Aktivlot eingesetzt wird, das ohne Flussmittel eine zur Herstellung der Lötverbindung ausreichende Benetzung der zu verbindenden Oberflächenbereiche erzielt. Die elektromagnetische Strahlung wird dabei durch eine der zu fügenden Komponenten hindurch, die wenigstens teilweise durchlässig für die elektromagnetische Strahlung ist, auf das Aktivlot gerichtet.

Das vorgeschlagene Verfahren ermöglicht das hochfeste und ausgasungsfreie Fügen der Bauteile auf die Trägerstruktur mittels einer Lötverbindung. Insbesondere lässt sich das Verfahren sehr vorteilhaft zur Montage optischer Komponenten auf Trägerstrukturen einsetzen. Durch die Nutzung geeigneter Aktivlote zum Fügen wird gemäß der Erfindung auf eine metallische Beschichtung der zu fügenden Komponenten Z verzichtet, und und ohne Verwendung von Flussmitteln eine ausreichende Benetzung und robuste Verbindung erzielt werden. Als Aktivlote können beispielsweise mit seltenen Erden dotierte Universallote eingesetzt werden, wie sie in der eingangs genannten Veröffentlichung von S. Jin beschrieben sind. Auch andere Aktivlote, beispielsweise hochschmelzende Aktiv-Hartlote, wie sie zum Beispiel zum Fügen von Diamantbauteilen Verwendung finden, können eingesetzt werden. Durch den Verzicht auf eine metallische Beschichtung der zu verbindenden Oberflächenbereiche lässt sich gemäß der Erfindung das vorgeschlagene Verfahren kostengünstig im industriellen Maßstab durchführen und die eingangs in Verbindung mit den Beschichtungsprozessen beschriebenen Nachteile werden vermieden. Es lassen sich somit unbeschichtete Bauteile mit der elektromagnetischen Strahlung flussmittelfrei verlöten. Durch die Einkopplung der elektromagnetischen Strahlung durch eine der zu verbindenden Komponenten hindurch direkt in das Lot wird ein einfacher, stabiler und günstiger Fügeprozess erreicht.

Das Verfahren wird zur Befestigung und Justage von optischen, insbesondere mikrooptischen Bauteilen auf Trägerstrukturen verwendet. Das Verfahren eignet sich besonders für Verbindungen, bei denen hohe Anforderungen an die Verbindungsqualität, Ausgasungsfreiheit und eine wiederholte Justierbarkeit gestellt werden. Dies kann beispielsweise bei der Montage von laseroptischen Aufbauten im industriellen Einsatz in harscher Umgebung sowie im Weltraumeinsatz der Fall sein. Auch passive optische Instrumente wie Spektrometer oder Kameras können mit dem vorgeschlagenen Verfahren günstig aufgebaut werden. So lässt sich beispielsweise ein unbeschichtetes Linsensystem mittels Laserstrahlung mit einer metallischen Trägerstruktur verbinden und im Lot hinsichtlich Position und Ausrichtung korrigieren. Es können mit diesem Verfahren auch Optiken mit einer einfachen Trägerstruktur verbunden werden, die dann durch mechanische Nachbearbeitung im Hinblick auf die optischen Eigenschaften der Optiken präzise mechanische Schnittstellen erhalten.

### Kurze Beschreibung der Zeichnungen

Das vorgeschlagene Erfahren wird nachfolgend anhand von Ausführungsbeispielen in Verbindung mit den Zeichnungen nochmals näher erläutert. Hierbei zeigen:
- Fig. 1: ein erstes Beispiel für die Verbindung eines optischen Bauteils mit einer Trägerstruktur gemäß dem vorgeschlagenen Verfahren;
- Fig. 2: ein zweites Beispiel für die Verbindung eines optischen Bauteils mit einer Trägerstruktur gemäß dem vorgeschlagenen Verfahren;
- Fig. 3: ein drittes Beispiel für die Verbindung eines optischen Bauteils mit einer Trägerstruktur gemäß dem vorgeschlagenen Verfahren;
- Fig. 4: ein viertes Beispiel für die Verbindung eines optischen Bauteils mit einer Trägerstruktur gemäß dem vorgeschlagenen Verfahren;
- Fig. 5: ein fünftes Beispiel, das drei Varianten für die Verbindung eines optischen Bauteils mit einer Trägerstruktur gemäß dem vorgeschlagenen Verfahren zeigt;
- Fig. 6: ein sechstes Beispiel für die Verbindung eines optischen Bauteils mit einer Trägerstruktur gemäß dem vorgeschlagenen Verfahren;
- Fig. 7: ein siebtes Beispiel für die Verbindung von optischen Bauteilen mit einer Trägerstruktur gemäß dem vorgeschlagenen Verfahren;
- Fig. 8: ein achtes Beispiel für die Verbindung eines optischen Bauteils mit einer Trägerstruktur gemäß dem vorgeschlagenen Verfahren;
- Fig. 9: ein neuntes Beispiel für die Verbindung eines optischen Bauteils mit einer Trägerstruktur gemäß dem vorgeschlagenen Verfahren;
- Fig. 10: ein zehntes Beispiel für die Verbindung eines optischen Bauteils mit einer Trägerstruktur gemäß dem vorgeschlagenen Verfahren;
- Fig. 11: eine Ausgestaltung von Verbindungselementen bei dem Verfahren der Figur 9 in Seitenansicht und Draufsicht; und
- Fig. 12: eine weitere Ausgestaltung von Verbindungselementen bei dem Verfahren der Figur 9 in Seitenansicht und Draufsicht.

### Wege zur Ausführung der Erfindung

Bei dem vorgeschlagenen Verfahren werden besondere aktive Lote in Verbindung mit einem Transmissionslötverfahren für die Verbindung der Bauteile mit einer Trägerstruktur eingesetzt, die ohne eine metallische Beschichtung der Fügepartner und ohne Verwendung von Flussmitteln eine Benetzung und robuste Verbindung erzielen. Als elektromagnetische Strahlung wird dabei vorzugsweise Laserstrahlung eingesetzt. Im Folgenden werden zahlreiche Beispiele für die Führung der elektromagnetischen Strahlung zum Aktivlot erläutert.

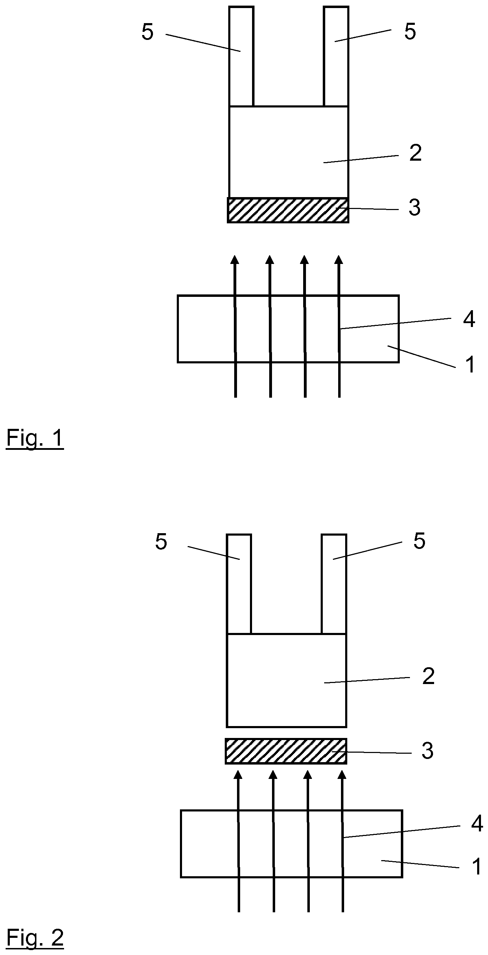

So zeigt Figur 1 ein Beispiel für die Verbindung eines Bauteils 2 mit einer Trägerstruktur 1, bei dem die elektromagnetische Strahlung 4 durch die Trägerstruktur 1 hindurch in das Aktivlot 3 eingestrahlt wird. Das Aktivlot 3 wurde zuvor mit einem geeigneten Verfahren auf den zu verbindenden Oberflächenbereich des Bauteils 2 aufgebracht. Dies kann beispielsweise durch direktes Aufbringen mit Ultraschallunterstützung, durch Bedampfung, durch Reflow-Vorlötung oder unterstützt mit elektromagnetischer Strahlung wie beispielsweise Laserstrahlung erfolgen. Es besteht in diesem Beispiel eine stoffschlüssige Verbindung zwischen dem Bauteil 2 und dem Aktivlot 3. Über die elektromagnetische Strahlung 4 wird derart Energie in das Aktivlot 3 eingekoppelt, dass es zur Aufschmelzung des Aktivlotes 3 kommt. Das Bauteil 2 wird mit einem Greifer 5, beispielsweise einem Vakuumgreifer, gefasst und zu der Trägerstruktur 1 geführt. Die Benetzung des Aktivlotes 3 auf der Oberfläche der Trägerstruktur 1 erfolgt direkt. Die Leistung der elektromagnetischen Strahlung 4 wird nach dem Aufschmelzen des Aktivlotes 3 wieder reduziert, so dass es zu einer Erstarrung des Aktivlotes 3 kommt. Der Greifer 5 wird anschließend entfernt. Die Fügung ist damit abgeschlossen.

Für eine Nachjustage kann das Bauteil 2 mit dem Greifer 5 fixiert, das Lot 3 wiederum mittels der elektromagnetischen Strahlung 4 aufgeschmolzen und das Bauteil 2 dann über den Greifer 5 neu ausgerichtet werden. Die Erstarrung des Lotes 3 und das Entfernen des Greifers 5 erfolgen wie bereits beschrieben.

Ein Spezialfall stellt die Befestigung von optischen Komponenten als Bauteile 2 dar. Hierbei wird während der Schmelzphase gegebenenfalls noch eine Justage von Ort und Winkel des Bauteils 2 mit Hilfe des Greifers 5 vorgenommen. Die optimierte Position bzw. der optimierte Winkel des Bauteils 2 wird dann über den Greifer 5 fixiert. Anschließend erfolgt wiederum die Erstarrung des Aktivlotes 3 wie oben beschrieben.

Alternativ zu der Vorgehensweise der Figur 1 kann das Aktivlot 3 auch ohne stoffschlüssige Verbindung zwischen beide Fügepartner, das heißt zwischen das Bauteil 2 und die Trägerstruktur 1, eingebracht werden. So kann beispielsweise eine Lotpreform aus dem Aktivlot 3 zwischen beide Fügepartner eingelegt werden. Das Aktivlot 3 wird dann mit der elektromagnetischen Strahlung 4 aufgeschmolzen, wie bei Figur 1 beschrieben. Die Benetzung der zu verbindenden Oberflächenbereiche erfolgt nach der Aufschmelzung bei beiden Fügepartnern wiederum aufgrund des Aktivlotes 3 automatisch. Weiterhin kann wie in Verbindung mit Figur 1 beschrieben auch eine Justage des Bauteils 2 erfolgen. Dieser Prozess ist schematisch in Figur 2 dargestellt.

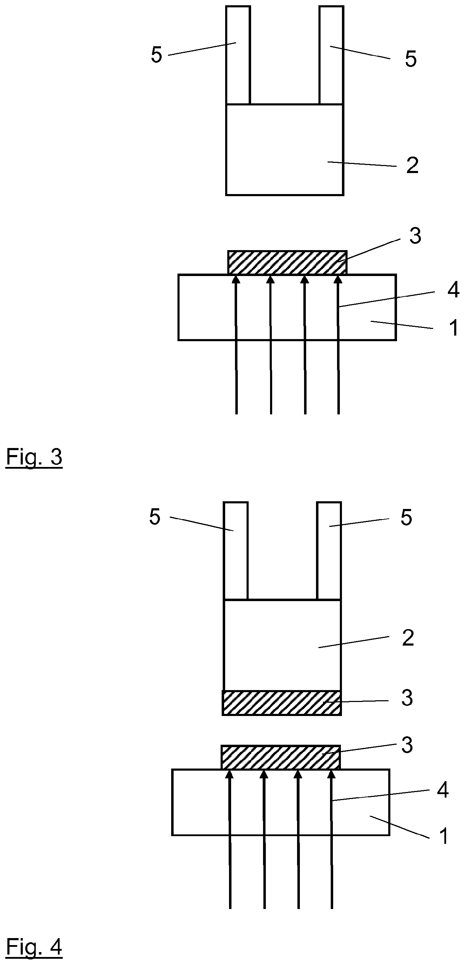

Figur 3 zeigt eine weitere Ausgestaltung, bei der das Aktivlot 3 vorher mit einem geeigneten Verfahren nicht mit dem Bauteil 2 wie bei Figur 1 sondern mit der Trägerstruktur 1 verbunden wurde. Die weitere Vorgehensweise entspricht dem Verfahren der Figur 1.

Auch eine Kombination der in Verbindung mit den Figuren 1 und 3 beschriebenen Techniken ist möglich. Hierbei wird auf beide Fügepartner 1, 2 Aktivlot 3 aufgebracht, wie dies in Figur 4 schematisch dargestellt ist. Das Lot auf einem der Fügepartner wird dann mittels elektromagnetischer Strahlung 4 aufgeschmolzen. Durch Kontakt der beiden Lotschichten schmilzt ebenfalls das Lot auf dem zweiten Fügepartner auf, so dass nach dem Abkühlen eine stoffschlüssige Verbindung zwischen den beiden Fügepartner 1, 2 entsteht.

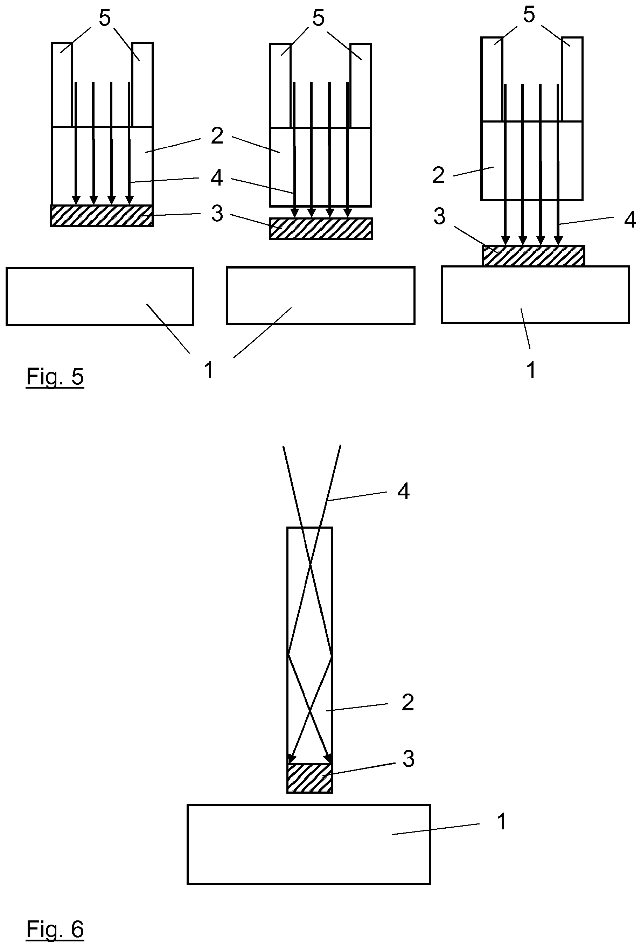

Die in Verbindung mit den Figuren 1 bis 4 beschriebenen Verfahren sind technisch nur dann realisierbar, wenn die Trägerstruktur 1 ausreichend durchlässig für die eingesetzte elektromagnetische Strahlung ist. Ist dies nicht der Fall, so kann die Strahlung auch durch das Bauteil 2 eingekoppelt werden, falls dieses eine ausreichende Durchlässigkeit für die elektromagnetische Strahlung aufweist. Dies ist insbesondere der Fall bei der Montage optischer Komponenten, insbesondere aus Glas, als Bauteil 2 auf metallischen oder auch keramischen Trägerstrukturen 1. Dies gilt sowohl für passive Instrumente wie beispielsweise Kameras als auch für aktive optische Instrumente wie beispielsweise Laser. Wie bei den Figuren 1 bis 3 kann auch hier das Aktivlot 3 zuvor entweder stoffschlüssig mit dem Bauteil 2 und/oder mit der Trägerstruktur 1 verbunden werden oder ohne stoffschlüssige Verbindung zwischen die zu fügenden Komponenten 1, 2 eingebracht werden. Drei Varianten sind schematisch in Figur 5 dargestellt.

Insbesondere bei der Verwendung von optischen Bauteilen mit einem hohen Aspektverhältnis (Verhältnis Länge zur Befestigungsfläche) kann eine einfache Durchstrahlung wie bei Figur 5 aufgrund einer schlechten Zugänglichkeit oder begrenzter Brillanz (Leistung pro Divergenzwinkel und Fokusfleckgröße) der Strahlung 4 limitiert sein. In diesem Fall kann die Strahlung durch Wellenleitung in dem Bauteil 2 geführt und an die Stelle des Aktivlotes 3 gebracht werden. Aufgrund der Strahldivergenz ist hier ein geringer Abstand zwischen Aktivlot 3 und optischem Bauteil 2 besonders günstig. Ansonsten sind alle vorgenannten Variationen der Aufbringung bzw. Einbringung des Aktivlotes 3 anwendbar. Figur 6 zeigt diese Technik stark schematisiert beispielhaft, bei der das optische Bauteil 2 als Wellenleiter für die Führung der elektromagnetischen Strahlung eingesetzt wird. In diesem Beispiel ist das Aktivlot 3 auf der zu verbindenden Oberfläche des Bauteils 2 aufgebracht.

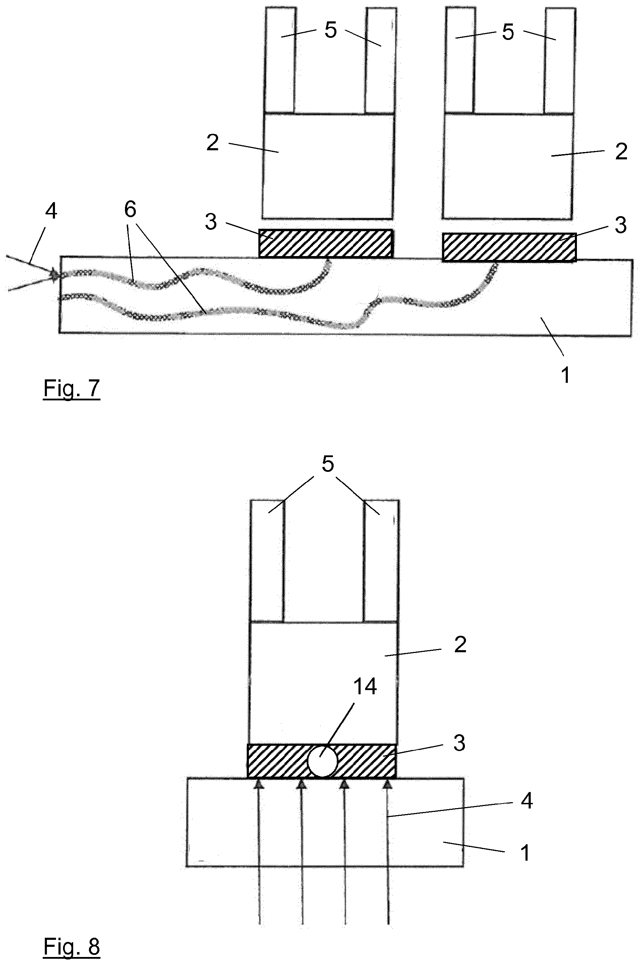

Alternativ kann die elektromagnetische Strahlung 4 auch in Wellenleitern 6 geführt werden, die entweder in das Bauteil 2, in die Trägerstruktur 1 oder in den Greifer 5 integriert werden. Bei der Montage von mehreren Bauteilen 2 auf einer Trägerstruktur 1 besteht eine vorteilhafte Ausgestaltung darin, für jedes zu montierende Bauteil 2 einen eigenen Wellenleiter 6 in die Trägerstruktur 1 zu integrieren, wie dies schematisch in Figur 7 dargestellt ist. Die Orte der Strahleinkopplung in diese Wellenleiter 6 werden dabei vorteilhaft leicht zugänglich und nahe beieinander angeordnet, so dass eine einzige Strahlquelle zur Erzeugung der Strahlung 4 verwendet werden und die Strahlung 4 durch laterale Verschiebung der Strahlungsquelle oder eines Strahlführungselementes für die Strahlung 4 in den jeweiligen Wellenleiter 6 eingekoppelt werden kann. Maßgeschneiderte Wellenleiterstrukturen lassen sich beispielsweise mit lasergestützter Mikrostrukturierung im optischen Material herstellen. Hierbei werden durch Pulse mit Pulsdauern von typischerweise Femtosekunden die lokalen Brechungsindexeigenschaften entsprechend manipuliert.

Besonders vorteilhaft ist hierbei die Verwendung einer Trägerstruktur 1 mit einer geringen Wärmeleitung, beispielsweise einer Trägerstruktur aus Titan, Zerodur, AL₂O₃ oder Edelstahl. Hierdurch kann eine lokale Aufschmelzung des Aktivlotes 3 am Befestigungsbereich einer Komponente leicht erreicht werden, ohne die Aktivlote an benachbarten Befestigungsbereichen der anderen Komponenten aufzuschmelzen.

Zur Einstellung eines definierten Lotspaltes unter Bewahrung der Justagefunktion kann in den Lotspalt ein Distanzhalter 14, beispielsweise in Form einer Sphäre, eingebracht werden, wie dies in Figur 8 schematisch dargestellt ist. Dieser Distanzhalter 14 wird so gewählt, dass er auch beim Aufschmelzen des Aktivlotes 3 in festem Aggregatzustand verbleibt. Es können auch mehrere Distanzhalter verwendet werden. Im Falle von nicht zu justierenden Bauteilen kann das Bauteil 2 beispielsweise über drei Sphären im Winkel fixiert werden. Alternative Strukturen zur Fixierung lassen sich auch in das Bauteil 2 oder in die Trägerstruktur 1 einbringen.

Durch Verwendung von ferromagnetischen Distanzhaltern 14, beispielsweise ferromagnetischen Sphären, kann eine Zuheizung im Zentrum des Aktivlotes 3 durch Ummagnetisierung (mittels Induktionsfeld) der Sphären erfolgen. Dadurch wird der Aufschmelzprozess für das Aktivlot 3 beschleunigt. Eine Zuheizung des Lotes kann auch ohne Sphäre oder Distanzhalter durch induktives Einkoppeln von Strömen im Aktivlot 3 erfolgen.

In einer vorteilhaften Ausgestaltung wird als elektromagnetische Strahlung 4 gepulste Strahlung verwendet. Die Pulsparameter werden dabei so gewählt, dass die Strahlung Schallwellen in dem Aktivlot 3 induziert, die die Benetzung des Aktivlotes 3 auf den Fügepartnern verbessern. Typischerweise werden bei der Verwendung von Ultraschallsonden mit einer Schallleistung von 20 W bei einer Sondenfläche von etwa 20 mm² und einer Schallfrequenz von ca. 10 kHz gute Benetzungsergebnisse erzielt. Bei der hier vorgeschlagenen Nutzung gepulster Strahlung lassen sich mit Pulsdauern im Nano- bis Mikrosekundenbereich noch hohe Schalleffizienzen erreichen. Bei einer Absorption von 20% im Lotmaterial müssen für gute Benetzungsergebnisse also etwa 100 W mittlere Laserleistung aufgebracht werden. Dies kann bei Wellenlängen um 1 µm mit Festkörperlasern und Faserlasern und bei Pulsdauern im Bereich von Mikrosekunden auch mit Diodenlasern erreicht werden. Um eine thermische Überanspruchung des Bauteils durch den gepulsten Laserstrahl zu verhindern, kann ein entsprechend kleiner Laserfleck bei reduzierter mittlerer Leistung aber gleicher Leistungsdichte eingesetzt werden, der scannend über die Fläche geführt wird.

Eine weitere günstige Anordnung besteht darin, mit Hilfe eines Schwingungssensors (z.B. Laservibrometer) die Schwingungseigenschaften an dem Lötinterface während des Vorgangs zu messen und dadurch die Benetzung zu bewerten und ggf. über eine Rückkopplung den Prozess zu steuern. Es ist davon auszugehen, dass bei erfolgter Benetzung ein minimaler Materialdichteübergang erfolgt, wodurch die Reflexion und Brechung von Schallwellen an dem Interface detektierbar minimiert werden.

Zur Verbesserung der Benetzung ist es auch möglich, eine Ultraschallquelle in den Greifer 5 zu integrieren.

Weiterhin können örtlich und/oder zeitlich variable Strahlverteilungen zur Reduktion oder Vermeidung von Spannungen in dem Bauteil 2 und/oder der Trägerstruktur 1 eingesetzt werden. Zusätzlich kann in diesem Fall auch eine aktive Rückkopplung einer Messung, beispielsweise Spannung durch Depolarisation oder Thermographie der Fügestelle, zur aktiven Steuerung der Strahlverteilung verwendet werden. Eine günstige örtliche Strahlverteilung ist beispielsweise dann gegeben, wenn an der Fügefläche oder in dem Bauteil eine räumlich konstante Temperatur erreicht wird. Da es an den Bauteilgrenzen üblicherweise zu einer stärkeren Abkühlung kommt als im Zentrum des Bauteils, kann eine günstige Verteilung darin bestehen, das Zentrum der Fügefläche schwächer als den Rand zu bestrahlen.

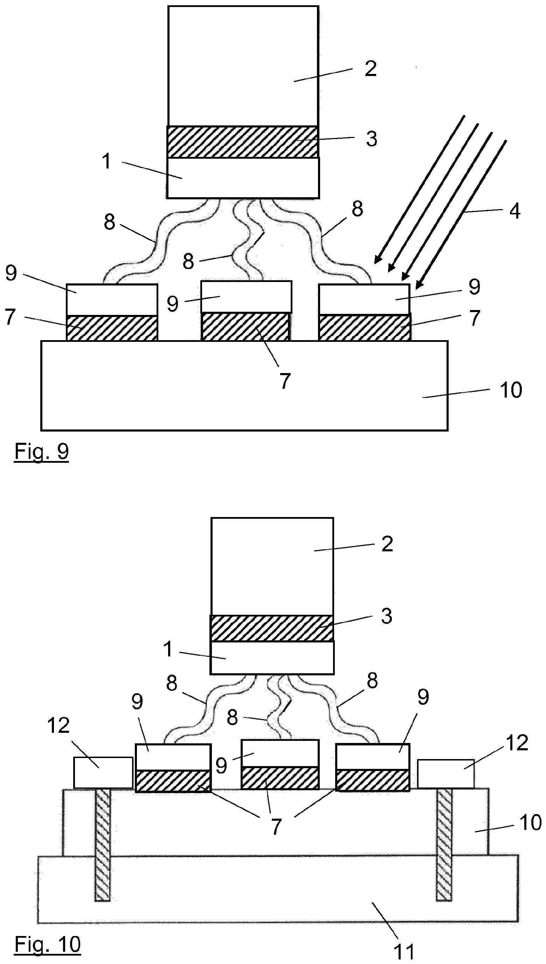

Die Figuren 9 bis 12 zeigen Ausführungsbeispiele für besondere Ausgestaltungen der Verbindung optischer Komponenten mit einer Gesamtträgerstruktur 10, wie sie mit dem vorgeschlagenen Verfahren herstellbar sind. Sie lassen sich aber auch mit anderen Löttechniken und Lotmaterialien herstellen. Diese Ausgestaltungen sind vor allem für Anwendungen wichtig, bei denen die Wärmeausdehnungskoeffizienten der optischen Komponente 2 und der Gesamtträgerstruktur 10 sehr unterschiedlich sind. So kann beispielsweise die optische Komponente 2 aus Quarz und die Gesamtträgerstruktur 10 aus Aluminium bestehen. Soll eine derartige optische Komponente 2 mit der Gesamtträgerstruktur 10 verbunden werden, so ist eine direkte Verbindung der beiden Komponenten aufgrund der bei Temperaturänderungen auftretenden Spannungen und Kräften in der Haltbarkeit stark limitiert. Insbesondere kann es bei Temperaturänderungen leicht zu einer Verkippung der optischen Komponente 2 gegenüber der Gesamtträgerstruktur 10 kommen, die beispielsweise als Grundplatte ausgeführt sein kann. Daher wird für eine derartige Verbindung eine Anordnung vorgeschlagen, bei der die optische Komponente 2 zunächst mit dem vorgeschlagenen Verfahren mit einer ersten Trägerstruktur 1 verbunden wird, die einen ähnlichen Wärmeausdehnungskoeffizienten aufweist wie die optische Komponente 2. Diese erste Trägerstruktur 1 kann beispielsweise aus Titan gebildet sein. Hierbei kann auch eine Sandwichstruktur aus mehreren z.B. verlöteten Bestandteilen, beispielsweise Titan und Keramik, als erste Trägerstruktur 1 verwendet werden, die durch Stromzufuhr beheizt werden kann. Anschließend erfolgt eine isostatische Verbindung der ersten Trägerstruktur 1 über federnde Elemente 8 mit Fußelementen 9 als zweite Trägerstrukturen, die vorzugsweise zur Vermeidung der oben genannten Spannungen und Kräfte eine geringere Fläche aufweisen als die Kontaktfläche zwischen der ersten Trägerstruktur 1 und dem optischen Element 2. Die erste Trägerstruktur 1, das Federelement 8 und das Fußelement 9 sind im Idealfall aus demselben Material und monolithisch aufgebaut. Anschließend werden die Fußelemente 9 über eine Lötverbindung 7 mit der Gesamtträgerstruktur 10 verbunden. Das Ergebnis ist in Figur 9 schematisch dargestellt. Zur Heizung für diese Lötung kann beispielsweise elektromagnetische Strahlung 4 oder auch ein induktives Feld verwendet werden. Im Falle der elektromagnetischen Strahlung 4 wird vorzugsweise die gleiche Strahlquelle eingesetzt, wie sie bereits für die Verbindung der ersten Trägerstruktur 1 mit dem optischen Bauelement 2 genutzt wurde. Die Lötverbindung 7 kann wiederum aus einem Aktivlot gebildet sein, um ohne zusätzliche Beschichtungen eine ausreichende Benetzung der zu verbindenden Flächen zu erreichen.

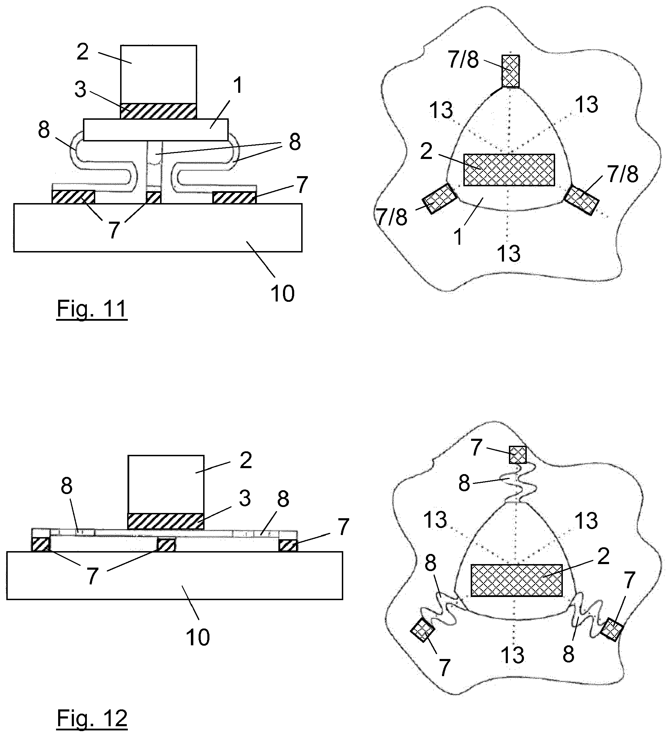

Besonders bei komplexeren Aufbauten können mehrere der in Figur 9 dargestellten Gesamtträgerstrukturen 10 auf einer Grundplatte 11 über idealerweise drei Verbindungspunkte verschraubt werden, wobei die Gesamtträgerstruktur 10 und die Grundplatte 11 so gewählt werden, dass sie ein ähnliches Wärmeausdehnungsverhalten aufweisen, insbesondere aus demselben Material bestehen. Durch diese Schraubverbindung 12, wie sie in Figur 10 dargestellt ist, können Gesamtträgerstrukturen 10 zusammen mit den darauf befindlichen Optiken einfach ausgetauscht werden. Dieses Prinzip gilt auch für die Gesamtträgerstrukturen 10, mit denen nur eine optische Komponente 2 verbunden ist. Die Figuren 11 und 12 zeigen jeweils vorteilhafte Ausführungsformen der Federelemente 8 einer Anordnung gemäß Figur 9 oder 10 in Seitenansicht und in Draufsicht. Bei der Ausgestaltung der Figur 11 wird die isostatische Verbindung der ersten Trägerstruktur 1 mit der Gesamtträgerstruktur 10 über die Federelemente 8 vornehmlich in einer Achse oder Ebene senkrecht zur Gesamtträgerstruktur 10 realisiert. In der Ausgestaltung der Figur 12 erfolgt die isostatische Verbindung der ersten Trägerstruktur 1 mit der Gesamtträgerstruktur 10 über die Federelemente 8 in einer Achse oder Ebene parallel zur Gesamtträgerstruktur 10.

In beiden Ausgestaltungen fällt der Verbindungspunkt 13 der Achsen der Bewegungsrichtungen der Federelemente 8 (der Ruhepunkt) mit dem relevanten Bereich der optischen Funktionsfläche des optischen Bauteils 2 zusammen. Hierdurch wird die Bewegung des optischen Bauteils 2 bei thermischen Wechsellasten minimiert. Wie aus den Figuren 11 und 12 ersichtlich ist, werden in diesem Beispiel jeweils drei um einen Winkel von 120° gegeneinander versetzte Federelemente 8 eingesetzt.

### Bezugszeichenliste

- 1: Trägerstruktur
- 2: Bauteil
- 3: Aktivlot
- 4: Elektromagnetische Strahlung
- 5: Greifer
- 6: Wellenleiter
- 7: Lötverbindung
- 8: Federelement
- 9: Fußelement
- 10: Gesamtträgerstruktur
- 11: Grundplatte
- 12: Schraubverbindung
- 13: Verbindungspunkt
- 14: Distanzhalter

## Patentansprüche

1. Verfahren zum Fügen von optischen Bauteilen (2), insbesondere von mikrooptischen Bauteilen, auf eine Trägerstruktur (1) unter Einsatz von elektromagnetischer Strahlung, wobei die Bauteile (2) und/oder die Trägerstruktur (1) als zu fügende Komponenten wenigstens teilweise durchlässig für die elektromagnetische Strahlung (4) sind, bei dem
- auf wenigstens einen von jeweils zwei zum Fügen zu verbindenden Oberflächenbereichen der Bauteile (2) und der Trägerstruktur (1) oder zwischen jeweils zwei zu verbindende Oberflächenbereiche der Bauteile (2) und der Trägerstruktur (1) ein Lot aufgebracht oder eingebracht wird, und
- die zu verbindenden Oberflächenbereiche anschließend durch Aufschmelzen des Lotes mit Hilfe der elektromagnetischen Strahlung (4) und anschließende Abkühlung stoffschlüssig miteinander verbunden werden,
**dadurch gekennzeichnet, dass**:
- auf eine metallische Beschichtung der zu verbindenden Oberflächenbereiche verzichtet wird,
- als Lot ein Aktivlot (3) eingesetzt wird, das ohne Flussmittel eine zur Herstellung einer Lötverbindung ausreichende Benetzung der zu verbindenden Oberflächenbereiche erzielt, und
- die elektromagnetische Strahlung (4) durch eine der zu fügenden Komponenten hindurch, die wenigstens teilweise durchlässig für die elektromagnetische Strahlung (4) ist, auf das Aktivlot (3) gerichtet wird.

2. Verfahren nach Anspruch 1,
**dadurch gekennzeichnet,**
**dass** das Aktivlot (3) unter Bildung einer stoffschlüssigen Verbindung auf den wenigstens einen zum Fügen zu verbindenden Oberflächenbereich aufgebracht wird.

3. Verfahren nach Anspruch 1,
**dadurch gekennzeichnet,**
**dass** das Aktivlot (3) ohne Bildung einer stoffschlüssigen Verbindung zwischen die jeweils zwei zu verbindenden Oberflächenbereiche eingebracht wird.

4. Verfahren nach einem der Ansprüche 1 bis 3,
**dadurch gekennzeichnet,**
**dass** die elektromagnetische Strahlung (4) durch Wellenleitung in den Bauteilen (2) zum Aktivlot (3) geführt wird, falls die Bauteile (2) eine für die Wellenleitung geeignete Form aufweisen.

5. Verfahren nach einem der Ansprüche 1 bis 3,
**dadurch gekennzeichnet,**
**dass** in die Trägerstruktur (1) oder die Bauteile (2) Wellenleiter (6) integriert sind oder werden, über die die elektromagnetische Strahlung (4) beim Fügen zum Aktivlot (3) geführt wird.

6. Verfahren nach einem der Ansprüche 1 bis 3 oder 5,
**dadurch gekennzeichnet,**
**dass** zum Fügen mehrerer Bauteile (2) an unterschiedlichen Fügepositionen der Trägerstruktur (1) mehrere Wellenleiter (6) in die Trägerstruktur (1) integriert sind oder werden, die zu den unterschiedlichen Fügepositionen führen, wobei die elektromagnetische Strahlung (4) jeweils zum Fügen eines der Bauteile (2) in den Wellenleiter (6) eingekoppelt wird, der zur Fügeposition für dieses Bauteil (2) führt.

7. Verfahren nach einem der Ansprüche 1 bis 6,
**dadurch gekennzeichnet,**
**dass** eine Trägerstruktur (1) aus einem nur gering wärmeleitfähigen Material, insbesondere mit einem Wärmeleitungskoeffizienten < 50 W/(m·K), eingesetzt wird.

8. Verfahren nach einem der Ansprüche 1 bis 7,
**dadurch gekennzeichnet,**
**dass** zur Einhaltung eines definierten Lotspaltes ein oder mehrere Distanzhalter (14) zwischen den zu verbindenden Komponenten eingesetzt werden.

9. Verfahren nach Anspruch 8,
**dadurch gekennzeichnet,**
**dass** der oder die Distanzhalter (14) aus einem ferromagnetischen Werkstoff gewählt werden und durch induktive Ummagnetisierung für eine zusätzliche Wärmeeinbringung in das Aktivlot (3) genutzt werden.

10. Verfahren nach einem der Ansprüche 1 bis 9,
**dadurch gekennzeichnet,**
**dass** eine zusätzliche Wärmeeinbringung durch induktives Einkoppeln von Strömen in das Aktivlot (3) erfolgt.

11. Verfahren nach einem der Ansprüche 1 bis 10,
**dadurch gekennzeichnet,**
**dass** die elektromagnetische Strahlung (4) als gepulste Strahlung auf das Aktivlot (3) gerichtet wird, die Schallwellen in dem Aktivlot (3) induziert, die die Benetzung des Aktivlotes (3) auf den zu verbindenden Oberflächenbereichen verbessern.

12. Verfahren nach einem der Ansprüche 1 bis 11,
**dadurch gekennzeichnet,**
**dass** die Benetzung des Aktivlotes (3) auf den zu verbindenden Oberflächenbereichen durch Einkopplung von Ultraschallwellen in wenigstens eine der zu fügenden Komponenten verbessert wird.

13. Verfahren nach einem der Ansprüche 1 bis 12,
**dadurch gekennzeichnet,**
**dass** als Aktivlot (3) ein mit seltenen Erden dotiertes Universallot eingesetzt wird.

14. Verfahren nach einem der Ansprüche 1 bis 13,
**dadurch gekennzeichnet,**
**dass** die elektromagnetische Strahlung (4) mit einer örtlich und/oder zeitlich variablen Strahlverteilung auf das Aktivlot (3) gerichtet wird, durch die mechanische Spannungen in dem Bauteil 2 und/oder der Trägerstruktur 1 beim Fügen verringert oder vermieden werden.

15. Verfahren nach den Ansprüchen 1 bis 14,
**dadurch gekennzeichnet,**
**dass** die Trägerstruktur (1) mit wenigstens einem damit verbundenen Bauteil (2) so über mehrere federnde Elemente (8) mit zweiten Trägerstrukturen (9) und die zweiten Trägerstrukturen (9) mit einer Gesamtträgerstruktur (10) verbunden werden, dass das wenigstens eine Bauteil (2) isostatisch mit der Gesamtträgerstruktur (10) verbunden ist.

16. Verfahren nach dem Anspruch 15,
**dadurch gekennzeichnet,**
**dass** die Trägerstruktur (1) über drei federnde Elemente (8) mit drei zweiten Trägerstrukturen (9) verbunden wird.

## Claims

1. Method for joining optical components (2), in particular micro-optical components, on a support structure (1) using electromagnetic radiation (4), wherein the components (2) and/or the support structure (1) as components to be joined are at least partially permeable to the electromagnetic radiation (4), in which
- a solder is applied to or introduced into at least one in each case of two surface areas that are to be connected for joining of the components (2) and the support structure (1), or between each of two surface areas that are to be connected of the components (2) and the support structure (1), and
- the surface areas that are to be connected are then materially bonded to one another by melting the solder with the aid of the electromagnetic radiation (4) and subsequent cooling,
**characterized in that**:
- a metal coating of the surface areas that are to be connected is dispensed with,
- an active solder (3) is used as solder, which achieves coverage of the surface areas to be connected that is sufficient for producing the solder joint without a fluxing agent, and
- the electromagnetic radiation (4) is directed onto the active solder (3) through one of the components to be joined, which is at least partially permeable to the electromagnetic radiation (4).

2. Method according to Claim 1,
**characterized in that**
the active solder (3) is applied to the at least one surface area to be connected for joining, forming a material bond.

3. Method according to Claim 1,
**characterized in that**
the active solder (3) is introduced between each of the two surface areas to be connected, without forming a material bond.

4. Method according to any one of Claims 1 to 3,
**characterized in that**
the electromagnetic radiation (4) is directed onto the active solder (3) by wave guidance in the components (2) if the components (2) have a shape suitable for wave guidance.

5. Method according to any one of Claims 1 to 3,
**characterized in that**
waveguides (6) via which the electromagnetic radiation (4) is guided to the active solder (3) during joining have been or are integrated in the support structure (1) or the components (2).

6. Method according to any one of Claims 1 to 3 or 5,
**characterized in that**
in order to join several components (2) at various joining positions of the support structure (1), a plurality of waveguides (6) have been or are integrated in the support structure (1) which lead to the various joining positions, wherein in order to joint one of the components (2) in each case the electromagnetic radiation (4) is coupled into the waveguide (6) that leads to the joining position for said component (2).

7. Method according to any one of Claims 1 to 6,
**characterized in that**
a support structure (1) made from a material which is only slightly thermally conductive, in particular with a coefficient of thermal conductivity < 50 W/(m·K), is used.

8. Method according to any one of Claims 1 to 7,
**characterized in that**
one or more spacers (14) are inserted between the components to be connected in order to maintain a defined solder gap.

9. Method according to Claim 8,
**characterized in that**
the one or more spacers (14) is/are selected from a ferromagnetic material and used to input additional heat into the active solder (3) by inductive reversal of magnetism.

10. Method according to any one of Claims 1 to 9,
**characterized in that**
an additional heat input is produced by inductive coupling of currents into the active solder (3).

11. Method according to any one of Claims 1 to 10,
**characterized in that**
the electromagnetic radiation (4) is directed onto the active solder (3) as pulsed radiation which induces sound waves in the active solder (3), which waves improve the coverage of the active solder (3) on the surface areas to be connected.

12. Method according to any one of Claims 1 to 11,
**characterized in that**
the coverage of the active solder (3) on the surface areas to be connected is improved by coupling ultrasonic waves into at least one of the components that are to be joined.

13. Method according to any one of Claims 1 to 12,
**characterized in that**
an all-purpose solder doped with rare earths is used as the active solder (3).

14. Method according to any one of Claims 1 to 13,
**characterized in that**
the electromagnetic radiation (4) is directed onto the active solder (3) with a spatially and/or temporally variable beam distribution, by means of which mechanical stresses in the component (2) and/or the support structure (1) are reduced or avoided during joining.

15. Method according to Claims 1 to 14,
**characterized in that**
the support structure (1) with at least one connected component (2) is connected to second support structures (9) via a plurality of resilient elements (8), and the second support structures (9) are connected to a total support structure (10) in such manner that the at least one component (2) is connected isostatically to the total support structure (10).

16. Method according to Claim 15,
**characterized in that**
the support structure (1) is connected to three second support structures (9) via three resilient elements (8) .

## Revendications

1. Procédé d'assemblage de composants optiques (2), notamment de composants micro-optiques, sur une structure porteuse (1), en utilisant un rayonnement électromagnétique, dans lequel les composants (2) et/ou la structure porteuse (1) en tant que composants à assembler sont au moins partiellement perméables au rayonnement électromagnétique (4), dans lequel
- sur au moins une des deux surfaces des composants (2) et du support à relier pour l'assemblage et la structure porteuse (1) ou entre deux surfaces respectives à relier des composants (2) et la structure porteuse (1) une brasure est appliquée ou introduite, et
- les surfaces à relier sont ensuite reliées les unes aux autres d'une manière liée matériellement par fusion de la brasure à l'aide d'un rayonnement électromagnétique (4) et refroidissement ultérieur,
**caractérisé en ce que** :
- un revêtement métallique des surfaces à relier est supprimé,
- une brasure active (3) est utilisée comme brasure qui, sans fondant, est utilisée pour produire un mouillage suffisant d'une liaison de brasure des surfaces de liaison réalisées, et
- le rayonnement électromagnétique (4) est dirigé à travers un des composants à assembler, qui est au moins partiellement perméable au rayonnement électromagnétique (4), sur la brasure active (3).

2. Procédé selon la revendication 1,
**caractérisé en ce que**
la brasure active (3) est appliquée en formant une liaison matérielle sur l'au moins une surface à relier pour l'assemblage.

3. Procédé selon la revendication 1,
**caractérisé en ce que**
la brasure active (3) est introduite entre les deux surfaces à relier sans former de liaison matérielle.

4. Procédé selon une des revendications 1 à 3,
**caractérisé en ce que**
le rayonnement électromagnétique (4) est guidé par conduction d'ondes dans les composants (2) jusqu'à la brasure active (3), au cas où les composants (2) présentent une forme appropriée pour la conduction d'ondes.

5. Procédé selon une des revendications 1 à 3,
**caractérisé en ce que**
dans la structure de support (1) ou les composants (2) des conducteurs d'onde (6) sont ou seront intégrés, par l'intermédiaire desquels le rayonnement électromagnétique (4) est guidé lors de l'assemblage à la brasure active (3).

6. Procédé selon une des revendications 1 à 3 ou 5,
**caractérisé en ce que**
pour assembler plusieurs composants (2) à différentes positions d'assemblage de la structure porteuse (1) plusieurs guides d'ondes (6) sont ou seront intégrés dans la structure porteuse (1), qui conduisent aux différentes positions d'assemblage, dans lequel le rayonnement électromagnétique (4) est couplé dans le guide d'ondes (6) pour l'assemblage d'un des composants (2), ce qui conduit à la position d'assemblage pour ce composant (2).

7. Procédé selon une des revendications 1 à 6,
**caractérisé en ce qu'**
une structure porteuse (1) constituée d'un seul matériau thermiquement conducteur, notamment avec un coefficient de conductivité thermique < 50 W/(m·K), est utilisée.

8. Procédé selon une des revendications 1 à 7,
**caractérisé en ce qu'**
une ou plusieurs entretoises (14) sont utilisées entre les composants à relier pour conserver un espace de brasure défini.

9. Procédé selon la revendication 8,
**caractérisé en ce que**
la ou les entretoises (14) sont choisies en un matériau ferromagnétique et sont utilisées par inversion magnétique inductive pour un apport supplémentaire de chaleur dans la brasure active (3).

10. Procédé selon une des revendications 1 à 9,
**caractérisé en ce que**
cet apport de chaleur supplémentaire a lieu par couplage inductif de courants dans la brasure active (3) .

11. Procédé selon une des revendications 1 à 10,
**caractérisé en ce que**
le rayonnement électromagnétique (4) est dirigé sous forme de rayonnement pulsé sur la brasure active (3), les ondes sonores sont induites dans la brasure active (3), ce qui améliore le mouillage de la brasure active (3) sur les surfaces à relier.

12. Procédé selon une des revendications 1 à 11,
**caractérisé en ce que**
le mouillage de la brasure active (3) sur les surfaces à assembler est amélioré par couplage d'ondes ultrasonores dans au moins un des composants à assembler.

13. Procédé selon une des revendications 1 à 12,
**caractérisé en ce qu'**
une brasure universelle dopée aux terres rares est utilisée comme brasure active (3).

14. Procédé selon une quelconque des revendications 1 à 13,
**caractérisé en ce que**
le rayonnement électromagnétique (4) est dirigé sur la brasure active (3) avec une distribution de faisceau variable dans l'espace et/ou dans le temps, grâce à quoi les contraintes mécaniques dans le composant (2) et/ou la structure porteuse (1) lors de l'assemblage sont réduites ou évitées.

15. Procédé selon les revendications 1 à 14,
**caractérisé en ce que**
la structure porteuse (1) avec au moins un composant qui lui est associé (2) par l'intermédiaire de plusieurs éléments élastiques (8) avec les deuxièmes structures porteuses (9) et les deuxièmes structures porteuses (9) avec une structure porteuse globale (10), de sorte que au moins un composant (2) soit relié de manière isostatique avec la structure porteuse globale (10).

16. Procédé selon la revendication 15,
**caractérisé en ce que**
la structure de support (1) est reliée par l'intermédiaire de trois éléments élastiques (8) avec trois deuxièmes structures porteuses (9).
